# EUROPEAN PATENT APPLICATION

(11) **EP 2 330 618 A1**
(43) Date of publication of application: **08.06.2011**
(21) Application number: 09306179.4
(22) Date of filing: 04.12.2009
(51) Int. Cl.: H01L 21/56, H01L 23/31, H01L 23/538

(54) **Rebuilt wafer assembly**

(71) Applicant: STMicroelectronics (Grenoble 2) SAS, 38000 Grenoble (FR)
(72) Inventor: Vittu, Julien, 38250 Villard De Lans (FR)
(74) Representative: de Beaumont, Michel

(57) **Abstract**

The invention concerns an electronic component package comprising an electronic component (1) having a circuit surface, a block of resin (3) partially surrounding said electronic component, and a multi-layer interconnection (6) in contact with said circuit surface, wherein said multi-layer interconnection (6) is connected to bond-pads having a pitch lower than 50 µm, and said block of resin (3) is made of injection-molding resin.

## Description

### FIELD OF THE INVENTION

The present invention relates to packages for electronic components, particularly but not exclusively to semiconductor components.

### BACKGROUND OF THE INVENTION

Many components are packaged in ball-grid array packages where the die, in the case of semiconductors, is placed on a substrate which provides the connections between the contact pads on the die and the outside world.

This substrate has an associated material cost and a minimum thickness which is of the order of 200 µm.

It is always desirable to reduce the size and cost of electronic components.

In the following description and the associated figures, same elements are designated by same references.

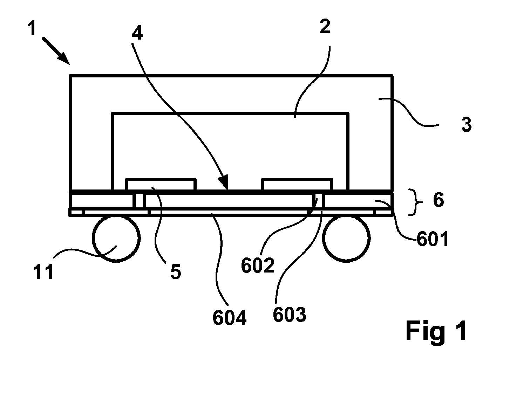

Figure 1 represents, in cross-section, a package according to a recent development in the field of ball-grid array (BGA) packages.

In a packaged electronic component 1, a die 2 is partially encased in a block of resin 3. The die 2 has an active surface 4 free of resin and on the active surface 3 are bond-pads 5. A multi-layer interconnection 6, comprising dielectric layers 601, conductive vias 602 and conductive tracks 603, is attached to the active surface 3. Typically, a passivation layer 604 is used to protect the conductive tracks 603.

The multi-layer interconnection 6 provides connections between the bond-pads 5 and solder-balls 11. The solder-balls 11 may be replaced by any other suitable method of connection such as solder paste lands. One layer of conductive tracks 603 and conductive vias 602 has been shown for simplicity but more may be used.

The package of Figure 1 no longer uses a substrate and so saves the associated cost. Since the multi-layer interconnection is much thinner than the equivalent substrate, the package height is reduced.

It is desirable to provide a process flow for manufacturing such a package that does not offset the gains in material cost by increasing the cost, relative to conventional packages, of other materials or processing steps. It is also desirable to obtain pin-counts at least as high as those of conventional packages.

### SUMMARY

Embodiments described herein address this need by providing an electronic component package comprising an electronic component which has a circuit surface, a block of resin partially surrounding said electronic component, and a multi-layer interconnection in contact with said circuit surface. The multi-layer interconnection is connected to bond-pads having a pitch lower than 50 µm, and said block of resin is made of injection-molding resin.

According to an embodiment, the multi-layer interconnection is no more than 30 µm thick.

According to an embodiment, the multi-layer interconnection is a thin-film structure.

According to an embodiment, the electronic component is a semiconductor.

According to an embodiment, the electronic components package has solder balls.

There is provided an electronic equipment comprising an electronic component package according to an embodiment.

There is also provided, a process of manufacturing the electronic component package comprising the steps of:
- providing a first plurality of electronic components, each having an active surface, held in a molded block of resin and placed on a first carrier,
- separating said plurality of electronic components into individual units by cutting the resin between said electronic components,
- removing said first support,
- positioning a second plurality of said individual units onto a second carrier, and
- forming interconnection layers on said active surfaces of said second plurality.

According to an embodiment, the process further comprises the step of placing a first dielectric layer on said active surfaces before the step of separating the plurality of electronic components into individual units.

According to an embodiment, the process further comprises the step of placing a seed layer upon said dielectric layer before the step of separating the plurality of electronic components into individual units.

According to an embodiment, the process uses a first carrier which is of a format compatible with equipment used for strip-molding ball-grid array packages.

According to an embodiment, the process uses a second carrier which has the form of a wafer compatible with silicon wafer processing equipment.

According to an embodiment, the process uses a second carrier which has the form of a 300 mm wafer.

According to an embodiment, the process step of forming the interconnection layers uses thin-film techniques.

According to an embodiment, the process comprises the further step of forming a passivation layer partially covering the interconnection layers.

### BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings wherein:
Fig 1 represents a cross-section of an electronic component package;
Fig 2 represents an assembly flow for manufacturing a package like that of Fig 1;
Figs 3a & 3b represent an assembly flow according to an embodiment;
Fig 4 represents a plan view of a carrier for use in the flow represented in Fig 3a;
Fig 5 represents a plan view of a carrier for use in the flow represented in Fig 3b; and
Fig 6 represents equipment incorporating an electronic component in a package according to an embodiment.

### DETAILED DESCRIPTION

In the following description, features which have already been described will not be described in further detail.

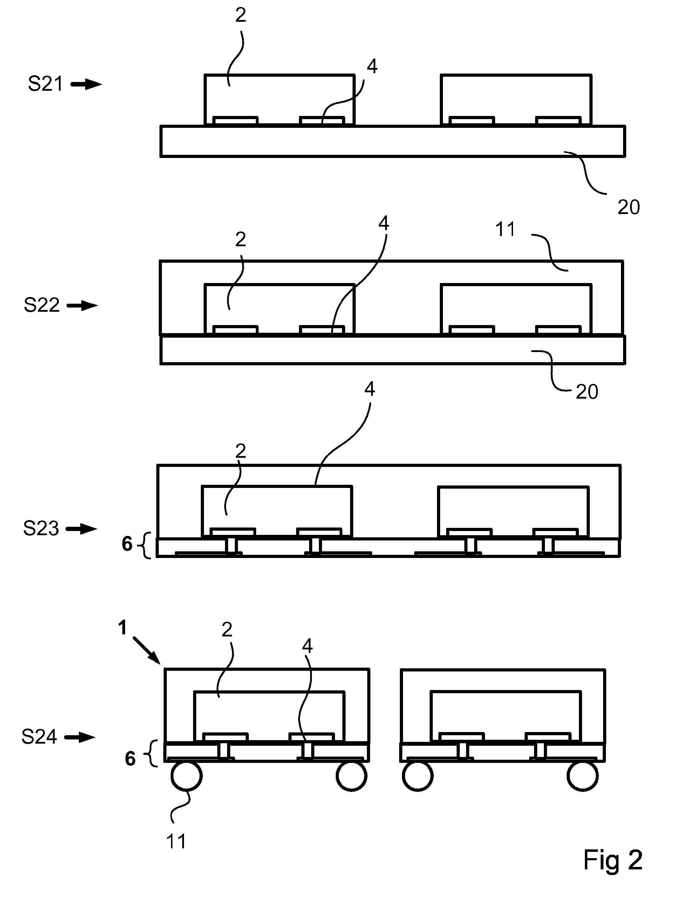

Figure 2 represents a possible process flow used to manufacture the package of Figure 1, in terms of cross-section views.

At step S21, dice 2 are placed active surface 4 down on a carrier 20. The carrier 20 has a circular form akin to that of a silicon wafer and is of dimensions compatible with silicon wafer processing equipment.

At step S22, a block of resin 21 is formed covering all the dice 2 by applying a liquid resin and then compressing the liquid resin into the assembly of the dice 2 on the carrier 20. The purpose of the compression is to force the liquid between the dice 2 and ensure a satisfactory encapsulation of the individual dice 2. The resin is then hardened and a structure resembling the format of a wafer is produced.

At step S23, the carrier 20 is removed and a multi-layer interconnection 6 is formed on the active surfaces 4 of the dice 2, using thin-film techniques.

If required, solder-balls 11 are attached at this stage. The multi-layer interconnection is around 20 µm thick. If more metal layers are used the thickness may increase to 30 µm.

At step S24, the individual components are separated into single electronic components 1.

The resin 21 in its hardened state has a different coefficient of thermal expansion than those of the dice and of the carrier. Furthermore, when it hardens, it changes volume. This has two effects: the relative positions of the dice 2 change in an unpredictable fashion and the 'wafer' tends to warp. The larger the wafer, the greater is the severity of these effects.

The subsequent steps of the process, i.e. the thin-film deposition of the multi-layer interconnect, are of a lithographic nature. They use masks which imply that the position of the features to which the connections are made be known. Also they require a certain degree of flatness.

This means that a size limit is imposed on the carrier which in turn means that the batch size is reduced and the processing cost is therefore higher than it would otherwise be.

A second consequence is that the minimum feature size that can be formed in the multi-layer interconnection 6 is larger than would normally otherwise be possible with typical processing like thin-film. This is important in that the pitch of the bond-pads 5 of the die 2 can be no finer than that of the multi-layer interconnect 6. Thus the die 2 could be forced to be larger than would otherwise be necessary, which is undesirable because die area is very expensive.

The current process limits are for carriers of 200 mm diameter and a minimum bond-pad pitch of the order of 70 µm.

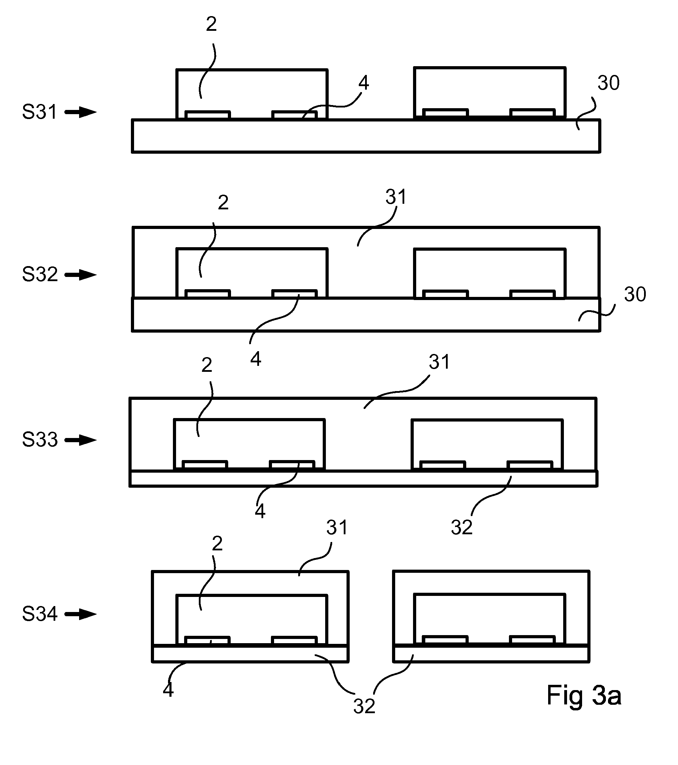

Figure 3a represents, in terms of cross-section views, a first part of a process flow according to an embodiment.

At step S31, dice 2 are placed with their active surfaces 4 down onto a first carrier 30. The first carrier 30 has an adhesive surface so as to maintain the dice 2 in place. It is desirable that the adhesive not contaminate the active surfaces 4 in a way that renders the attachment of the multi-layer interconnect 6 more difficult. It is also desirable that the first carrier 30 can be removed later without difficulty.

At step S32, a block of resin 31 is formed by injection molding so as to encapsulate the dice 2. An injection-molding process conventional to ball-grid BGA processing may be used. A dielectric layer 32 is deposited. Possible techniques for this can be thin-film or spin-coating of a liquid deposition.

The dielectric layer 32 forms the first part of a multi-layer interconnect. It is desirable that the dielectric layer 32 be of a material compatible with the thin-film techniques that will be later used to complete the multi-layer interconnect. It may also be convenient to deposit at this point any seed layers (not shown) necessary for the subsequent metal layers.

At step S34, the block of resin 31 and the dielectric layer 32 are cut between the dice 2 so as to produce individual partially processed units 33. Conventional cutting techniques such as sawing may be used.

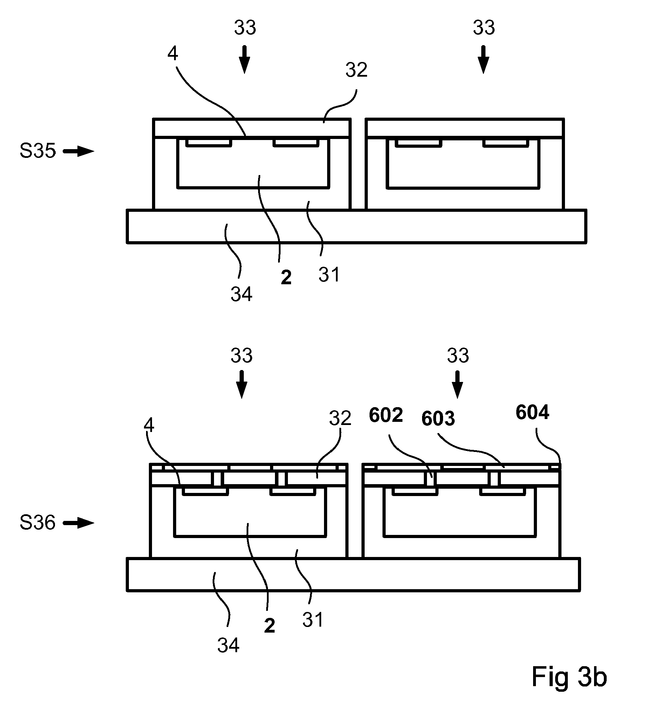

Figure 3b represents, in terms of cross-section views, a second part of a process flow according to an embodiment.

At step S35, the individual partially processed units 33 are attached to a second carrier 34, this time with active surfaces 4, and the dielectric layer 32 attached them, facing away from the second carrier 34. The second carrier 34 has an adhesive surface that retains the individual units 33 in place whilst allowing them to be removed in a satisfactory manner later.

The presence of the dielectric layer 32 may be helpful in preventing damage to the individual partially processed units 33 during the transfer process.

At step S36, a multi-layer interconnect 6 is completed, using thin-film techniques. Typically, this will involve creating vias 602 in the dielectric layer, creating conductive tracks 603 and creating a passivation layer 604. Solder-balls 11 may be added (not shown). As mentioned previously, more layers of conductive vias 602, conductive tracks 603 and dielectric layers 32 may be used.

After this, the individual completed components are removed from the second carrier 34.

It is desirable to place the individual units 33 with accurate equipment so that the masking steps of the subsequent thin-film processing may be aligned to a satisfactory degree. The more accurate the placement, the smaller may be made the features defined by the thin-film processing. It is possible, for example, to obtain a pitch of 40 µm for the connections to the bond-pads.

The decrease of the minimum pitch from 70 µm to 40 µm brings about a significant increase in the maximum pin-count of any given size of die 2.

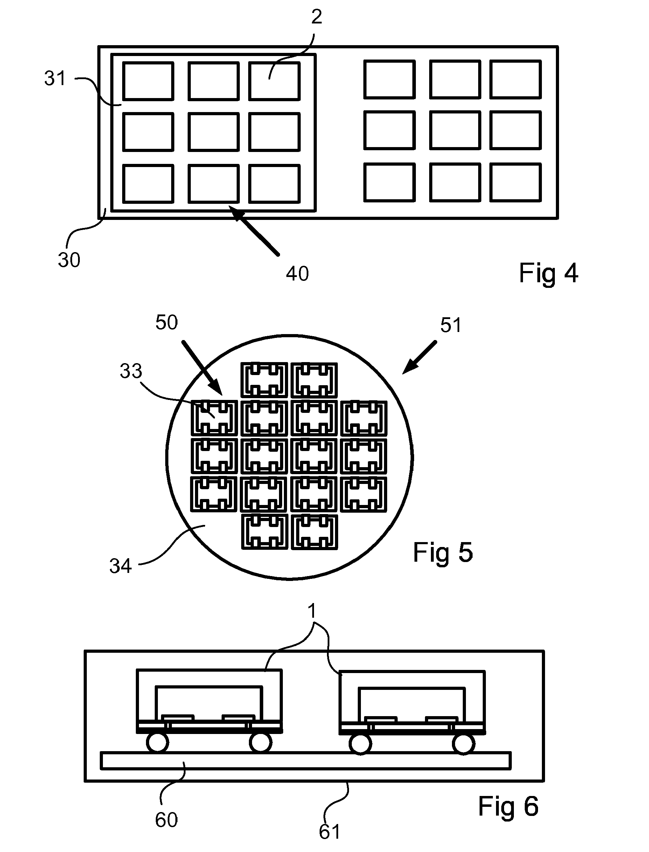

Figure 4 represents a plan view of an example of a first carrier 30 suitable for the first part of a process flow as described with reference to Figure 3a. The first carrier 30 has a rectangular form, advantageously compatible with conventional BGA processing equipment. The dice 2 are placed in a number of matrices 40, the number of dice in a matrix being determined by the size of the dice 2. A block of resin 31 is molded over each matrix 40.

Figure 5 represents a plan view of an example of a second carrier 34 suitable for the second part of a process flow as described with reference to Figure 3b. On the second carrier 34, is placed a matrix 50 of individual partially processed units 33. The construction 51 will be referred to as a "rebuilt wafer".

If the second carrier 34 has the circular form and standardized dimensions of a silicon wafer, it is possible to profit from equipment similar to that used in wafer fabrication for the forming of the multi-layer interconnect. Such equipment is better adapted to defining small features than is traditional package assembly equipment.

Furthermore, because the rebuilt wafer 51 is constructed from separate units rather than having resin over its entire surface, the problems associated with thermal expansion and the volume change of the resin are present to a much smaller degree. This means that the rebuilt wafer 51 suffers much less from warp and does not have the unpredictability of the position of the dice. Therefore the rebuilt wafers 51 can be made larger and finer features defined in the thin-film processing.

Thus the batch size is increased, reducing the process cost. Indeed rebuilt wafers of 300 mm diameter are considered possible, improving considerably over the 200 mm wafers possible to today.

Figure 6 represents a cross-section of an equipment comprising a printed circuit board 60 on which is mounted a plurality of electronic components 1 in packages according to the invention. The equipment has an outer casing 61, serving, amongst other things, to protect the electronics inside.

The foregoing is given purely by way of example and is, in no way, intended to be limitative. Indeed, other variants of the flow are possible. For example it may be possible to deposit the dielectric layer 32 or the seed layers at different points than those indicated. Also the multi-layer interconnect 6 may be manufactured using techniques other than thin-film processing.

Having thus described at least one illustrative embodiment of the invention, various alterations, modifications and improvements will readily occur to those skilled in the art. Such alterations, modifications and improvements are intended to be within the spirit and scope of the invention. Accordingly, the foregoing description is by way of example only and is not intended to be limiting. The invention is limited only as defined in the following claims and the equivalent thereto.

## Claims

1. An electronic component package comprising:
an electronic component (1) having a circuit surface,
a block of resin (3) partially surrounding said electronic component, and
a multi-layer interconnection (6) in contact with said circuit surface,
wherein said multi-layer interconnection (6) is connected to bond-pads having a pitch lower than 50 µm, and said block of resin (3) is made of injection-molding resin.

2. The electronic component package of claim 1, wherein the multi-layer interconnection is between 20 µm and 30 µm thick.

3. The electronic component package of claim 1 or 2, wherein the multi-layer interconnection is a thin-film structure.

4. The electronic component package of any one of the preceding claims, wherein the electronic component is a semiconductor.

5. The electronic components package of any one of the preceding claims, having solder balls (11).

6. An electronic equipment comprising an electronic component package according to any one of the preceding claims.

7. A process of manufacturing an electronic component package comprising the steps of:
providing a first plurality of electronic components (2), each having an active surface, held in a molded block of resin (31) and placed on a first carrier (20),
separating said plurality of electronic components into individual units by cutting the resin between said electronic components,
removing said first carrier,
positioning a second plurality of said individual units onto a second carrier (30), and
forming interconnection layers (32) on said active surfaces of said second plurality.

8. The process of claim 7, further comprising the step of placing a first dielectric layer on said active surfaces before the step of separating the plurality of electronic components into individual units.

9. The process of claim 8, further comprising the step of placing a seed layer upon said dielectric layer before the step of separating the plurality of electronic components into individual units.

10. The process of any one of claims 7 to 9, wherein the first carrier is of a format compatible with equipment used for strip-molding ball-grid array packages.

11. The process of any one of claims 7 to 10, wherein the second carrier has the form of a wafer compatible with silicon wafer processing equipment.

12. The process of claim 11, wherein the second carrier has the form of a 300 mm wafer.

13. The process of any one of claims 7 to 12, wherein the step of forming the interconnection layers uses thin-film techniques.

14. The process of any one of claims 7 to 13, comprising the further step of forming a passivation layer partially covering the interconnection layers.
